(19)

Europäisches Patentamt
European Patent Office
Office européen des brevets

(11) **EP 2 918 396 A1**

(12) **EUROPEAN PATENT APPLICATION**

(43) Date of publication:
**16.09.2015 Bulletin 2015/38**

(51) Int Cl.:
**B29C 67/00** (2006.01)   **B22F 3/105** (2006.01)
**B33Y 10/00** (2015.01)   **B33Y 30/00** (2015.01)
**B33Y 50/02** (2015.01)

(21) Application number: **15158295.4**

(22) Date of filing: **09.03.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **10.03.2014 JP 2014046686**

(71) Applicant: **JEOL Ltd.**
**Akishima,**
**Tokyo 196 (JP)**

(72) Inventor: **Honda, Kazuhiro**
**Akishima, Tokyo 196-8558 (JP)**

(74) Representative: **Boult Wade Tennant**
**Verulam Gardens**
**70 Gray's Inn Road**
**London WC1X 8BT (GB)**

(54) **Machine and method for additive manufacturing**

(57)   An additive manufacturing machine is offered which creates a three-dimensional (3D) object by melting a powdered material with a beam such an electron beam and which shapes the surface of the 3D object at improved accuracy. The 3D object is obtained by tightly spreading the powdered material (31) on a support stage (43) and illuminating the powdered material (31) with a beam (B) to melt and bond together grains of the powdered material. The beam generated by a beam generator (11) is a pulsed beam and used to melt or sublimate the powdered material.

Fig.1

EP 2 918 396 A1

**Description**

BACKGROUND OF THE INVENTION

1. Field of the Invention

The present invention relates to a machine and method for 'additive manufacturing', fabricating a three-dimensional object by illuminating a layer of a powdered material with a beam to form a solidified layer and repeating this process.

2. Description of the Related Art

In recent years, techniques for fabricating a three-dimensional (3D) object by creating two-dimensional data about slices of a given thickness of the 3D object from data about the 3D object, forming a solidified layer based on the two-dimensional data, and repeating this process have been developed (see patent document 1).

In such an additive manufacturing machine for fabricating a three-dimensional object, a powdered material for one layer is first supplied onto a support stage capable of moving up and down. A beam generator emits an electron beam or laser beam at the layer of the powdered material. At this time, the powdered material at a given position is molten by the beam by illuminating the powdered material with the beam while scanning the beam within a two-dimensional plane. Since the powdered material is molten, the molten grains of the powdered material bond together. The material is then cooled and solidified. As a result, one layer of solidified material is formed. Then, the support stage is lowered and additional powdered material is supplied. The powdered material is molten and solidified in the same way as in the previous steps. As a result, a second layer of solidified material is formed integrally with the previously formed, lower layer of solidified material. In this way, the support stage is lowered an incremental distance. A powdered material is supplied onto the stage. The powdered material is molten and solidified. This series of steps is repeated. Consequently, a three-dimensional object is fabricated.

Citation List

Patent Documents

Patent document 1: JP-A-2001-152204

The accuracy at which a three-dimensional object is fabricated by an additive manufacturing machine depends on the grain diameter of the powdered material and on the diameter of the illuminating beam. That is, it is desirable to reduce the grain diameter of the powdered material as much as possible in enhancing the accuracy of additive manufacturing. However, if the grain diameter of the powdered material is reduced, the thickness of each one layer of powdered material spread tightly on a support stage decreases. In this case, the number of layers of spread powdered material necessary to fabricate a three-dimensional (3D) object is increased. This in turn prolongs the time taken to fabricate the 3D object. In this way, it is not always desirable to reduce the grain diameter of the powdered material as much as possible.

Accordingly, the accuracy at which a three-dimensional multilayered object is fabricated depends strongly on the diameter of the illuminating beam. A major factor determining the accuracy at which a three-dimensional (3D) multilayered object is fabricated is the contour of the 3D object. Where it is assumed that the contour of the 3D object perfectly coincides with the positions scanned by the illuminating beam, if the scanning of the illuminating beam is improved, then the accuracy at which the contour of the 3D multilayered object is formed is improved.

In practice, however, when a powdered material is illuminated with a beam, heat of solution that is conducted through the powdered material is produced. As a result, even surroundings of the illuminated spots are molten. In this circumstance, the positions hit by the beam does not agree with the contour of the 3D object. Since melting and bonding of the grains of the powdered material through the conduction of the heat of solution is determined probabilistically, melting of even the surroundings of the illuminated spots will deteriorate the accuracy at which the contour of the 3D multilayered object is formed. This gives rise to a factor impairing the surface roughness of the 3D multilayered object.

The problems occurring when the contour of a three-dimensional multilayered object is formed have been described so far. When a beam scans locations other than the contour, it is important that the positions scanned by the beam agree with locations at which grains of a powdered material are molten and bonded together in enhancing the accuracy of additive manufacturing.

SUMMARY OF THE INVENTION

It would be desirable to provide a machine and method for additive manufacturing capable of precisely controlling locations at which a powdered material is molten by a beam.

According to the present invention, there is provided additive manufacturing machines as set out in claims 1 and 7 and methods of fabricating a three-dimensional multilayered object as set out in claims 11 and 12.

An additive manufacturing machine according to a first embodiment of the present invention has a support stage on which a powdered material is spread tightly, a beam generator producing a beam, a lens for focusing the beam produced by the beam generator onto the powdered material spread on the support stage, and a controller for controlling the beam generator. The controller causes the beam generator to selectively produce two kinds of beams, i.e., a continuous beam and a pulsed beam.

An additive manufacturing method according to a second embodiment of the present invention starts with spreading a powdered material tightly on a support stage. The material is illuminated with a beam to melt and bond together grains of the powdered material to obtain a 3D multilayered object. Two kinds of beams, i.e., a continuous beam and a pulsed beam, are selectively produced as the illuminating beam.

An additive manufacturing machine according to a third embodiment of the present invention has a support stage on which a powdered material is spread tightly, an electron gun producing an electron beam, a lens for focusing the electron beam produced by the electron gun onto the powdered material spread on the support stage, and a controller for controlling the electron gun. The controller causes the electron gun to generate a pulsed beam of electrons.

An additive manufacturing method according to a fourth embodiment of the present invention starts with spreading a powdered material tightly on a support stage. The material is illuminated with an electron beam to melt and cure the powdered material, thus obtaining a three-dimensional object. The electron beam produced by the electron gun is a pulsed beam and used to melt or sublimate the powdered material.

According to the first or second embodiment, a three-dimensional multilayered object can be obtained by using two kinds of beams, i.e., a continuous beam and a pulsed beam. The surface roughness of the additive manufacturing object can be improved and, at the same time, the speed at which the additive manufacturing object is produced can be increased, for example, by using the pulsed beam in forming the contour of the object and using the continuous beam in forming object portions other than the contour.

According to the third or fourth embodiment of the present invention, the pulsed electron beam is used as the electron beam used to obtain a three-dimensional multilayered object by melting and bonding together grains of a powdered material. Thus, an accurate additive manufacturing process can be performed in such a way that the beam diameter is substantially coincident with the range in which the material is molten. Consequently, the accuracy at which a three-dimensional multilayered object is fabricated can be improved.

BRIEF DESCRIPTION OF THE DRAWINGS

FIG. 1 is a schematic vertical cross section, partly in block form, of an additive manufacturing machine according to one embodiment of the present invention, showing the whole configuration of the machine.

FIG. 2 is a fragmentary perspective view of the additive manufacturing machine shown in FIG. 1, and in which a material is being illuminated with a beam to form the inside of the contour of a 3D object.

FIG. 3 is a fragmentary perspective view similar to FIG. 2, but showing the manner in which the material is being illuminated with a beam to form the contour.

FIG. 4 is an explanatory view showing the manner in which powder is molten and sublimated by illuminating the inside of design positions of a 3D object with a beam and illuminating the contour with a beam in accordance with one embodiment of the invention.

FIGS. 5A, 5C, and 5E are explanatory views of examples of characteristics of a continuous electron beam.

FIGS. 5B, 5D, and 5F are explanatory views of examples of characteristics of a pulsed electron beam.

FIG. 6A is an explanatory view showing the manner in which powder is being illuminated with a continuous beam in accordance with one embodiment of the invention.

FIG. 6B is an explanatory view showing the manner in which powder is being illuminated with a pulsed beam in accordance with one embodiment of the invention.

FIGS. 7A and 7B are explanatory views showing examples of positions illuminated with a pulsed beam to form a contour line in accordance with one embodiment of the invention. FIG. 8A is a view illustrating the diameters of a continuous beam and of a pulsed beam in accordance with one embodiment of the invention.

FIGS. 8B and 8C are graphs showing examples of drive currents for the pulsed beam.

FIG. 9 is a flowchart illustrating one example of a layer-wise additive manufacturing process sequence in accordance with one embodiment of the invention.

DESCRIPTION OF THE PREFERRED EMBODIMENTS

An additive manufacturing machine according to one embodiment of the present invention is hereinafter described with reference to the accompanying drawings.

1. Configuration of Additive manufacturing Machine

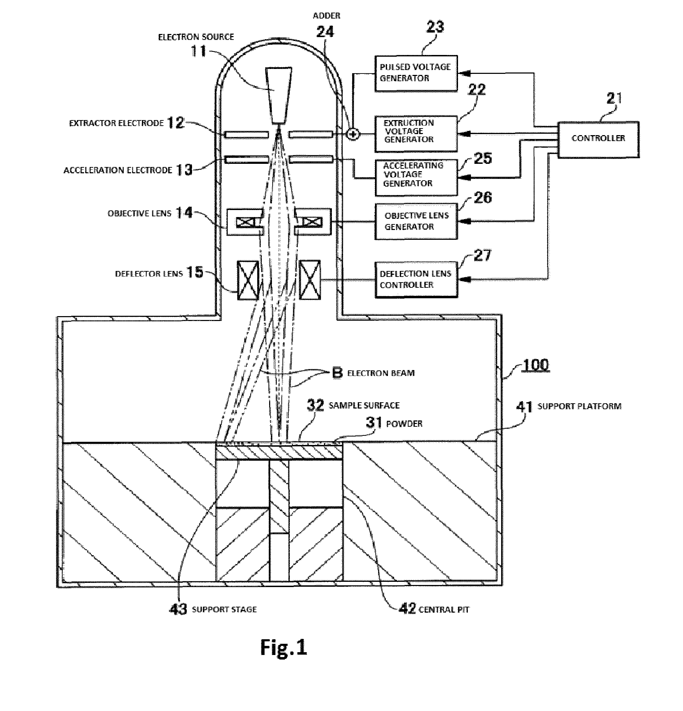

FIG. 1 schematically shows the configuration of the additive manufacturing machine, 100, according to one embodiment of the invention. The machine 100 has an electron source 11 emitting an electron beam B. An extractor electrode 12 and an acceleration electrode 13 are disposed near the electron source 11. The electron source 11, extractor electrode 12, and acceleration electrode 13 together operate as an electron gun generating and accelerating the electron beam.

Voltages are applied to the electron source 11, extractor electrode 12, and acceleration electrode 13 under control of a controller 21. In particular, an extraction voltage generator 22 generates an extraction voltage applied to the extractor electrode 12 under instructions from the controller 21. The extraction voltage generated by the extraction voltage generator 22 is an extraction voltage for a continuous electron beam (described later). A pulsed voltage generator 23 generates a pulsed voltage applied to the extractor electrode 12 under instructions from the controller 21. The pulsed voltage generated by the pulsed voltage generator 23 is an extraction voltage for a pulsed electron beam (described later).

The extraction voltage generated by the extraction voltage generator 22 and used for the continuous electron beam and the extraction voltage generated by the pulsed voltage generator 23 and used for the pulsed electron beam are supplied to the extractor electrode 12 via an adder 24. When the pulsed voltage generator 23 produces the pulsed electron beam, the extraction voltage generator 22 may produce a bias voltage (described later) for heating a powder 31. An accelerating voltage generator 25 generates an accelerating voltage applied to the acceleration electrode 13 under instructions from the controller 21. The accelerating voltage generated by the accelerating voltage generator 25 is impressed on the acceleration electrode 13. When the electron source 11 produces an electron beam, the electron source 11 is heated by a heater (not shown).

The electron beam B emitted from the electron source 11 is directed at the powder 31 spread tightly on a support stage 43. The powder 31 is spread tightly on the stage 43 to a given thickness by a linewise funnel (not shown). The electron beam B produced from the electron source 11 passes through an objective lens 14 and a deflector lens 15 and reaches the powder 31. Each of the objective lens 14 and deflector lens 15 is an electromagnetic lens producing an electric or magnetic field acting on the electron beam.

The objective lens 14 focuses the electron beam B onto the powder 31 located on the support stage 43 under control of an objective lens controller 26 that is controlled based on instructions from the controller 21. The deflector lens 15 deflects the electron beam B such that the electron beam B illuminates positions corresponding to the sliced shape of the 3D multilayered object to be fabricated. The deflector lens 15 operates to deflect the electron beam under control of a deflector lens controller 27 that is controlled based on instructions from the controller 21.

The support stage 43 is disposed in a central pit 42 formed in a support platform 41 and can move up and down. In an interlocking manner with the formation of each layer of the powder 31, the support stage 43 descends an incremental distance corresponding to the thickness of each layer. After one layer of the powder 31 is spread tightly on the support stage 43, the powder 31 is molten by the electron beam B in conformity with the shape of the 3D multilayered object to be fabricated. In the present embodiment, an operation for sublimating the powder 31 is performed apart from the operation for melting the powder.

The additive manufacturing machine 1 performs the operation for tightly spreading the powder 31 in a layerwise manner, the layer-wise operation for melting the powder 31, and the layer-wise operation for sublimating the powder 31 repeatedly to fabricate a three-dimensional object. The operation for illuminating the powder with the electron beam B is performed after the interior of the additive manufacturing machine shown in FIG. 1 has been evacuated by a vacuum pump (not shown).

2. Example of How Powder is Illuminated with Beam

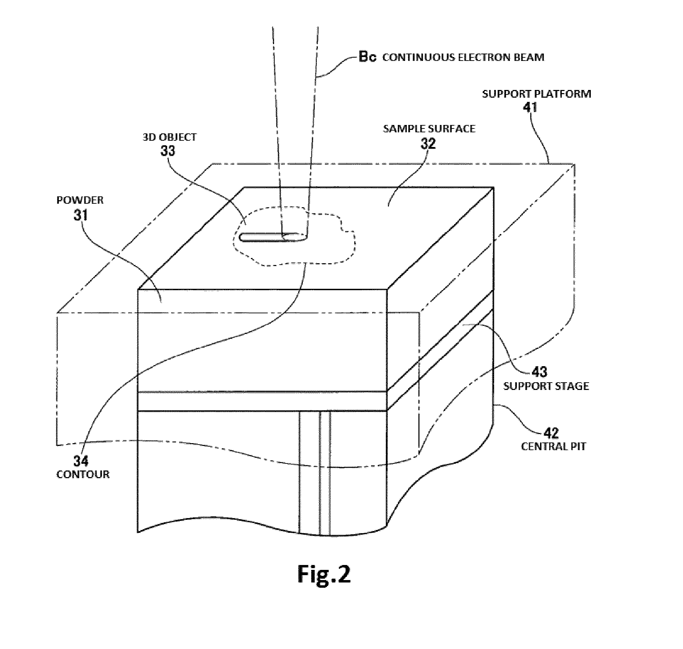

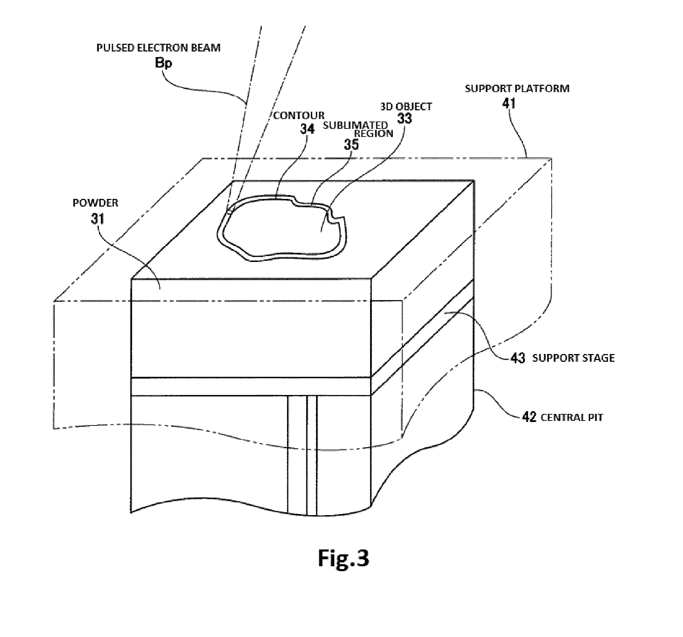

How powder is illuminated with a beam by the additive manufacturing machine according to one embodiment of the present invention is next described by referring to FIGS. 2-4. With the additive manufacturing machine 100 according to one embodiment of the invention, processing steps for illuminating the powder 31 with the electron beam B include two steps, i.e., a step of illuminating the contour of the 3D object and a step of illuminating the inside of the contour. FIG. 2 shows a state in which the inside of the contour is illuminated. FIG. 3 shows a state in which the contour is illuminated.

The state in which the inside of the contour of the 3D object is illuminated is first described by referring to FIG. 2. As shown in this figure, the powder 31 tightly spread over the support stage 43 is illuminated with the electron beam B. This electron beam B is emitted continuously by supplying electric power to the electron source 11 from a DC power supply and denoted as $B_c$. In the following description, this electron beam emitted continuously is referred to as the continuous electron beam. Grains of the powder 31 at the locations hit by the continuous electron beam $B_c$ melt and bond together.

When the powder 31 is illuminated with the electron beam, the controller 21 evaluates the positions of a contour 34 formed by slices of the created 3D object. The deflector lens controller 27 sets how the electron beam is deflected by the deflector lens 15 such that the continuous electron beam $B_c$ scans the region located inside of the evaluated contour 34.

When the illumination of the inside of the contour 34 with the continuous electron beam is complete, the deflector lens controller 27 sets how the electron beam is deflected by the deflector lens 15 such that locations along the contour 34 are scanned by the electron beam. That is, as shown in FIG. 3, the deflector lens controller 27 sets how the electron beam is deflected by the deflector lens 15 such that the electron beam $B_p$ makes one revolution along the contour 34. At this time, the pulsed voltage generator 23 applies a pulsed voltage to the extractor electrode 12. As a result, the electron source 11 outputs the pulse-like electron beam $B_p$. In the following description, this pulse-like electron beam is referred to as the pulsed electron beam.

The powder 31 is illuminated with the pulsed electron beam $B_p$. The powder 31 at the illuminated locations sublimates and evaporates. Therefore, when illumination by the pulsed electron beam $B_p$ for one layer is complete, it follows that a 3D object 33 having one layer of contour 34 has been formed. The principle on which the powder 31 illuminated with the pulsed electron beam $B_p$ sublimates and evaporates will be described later.

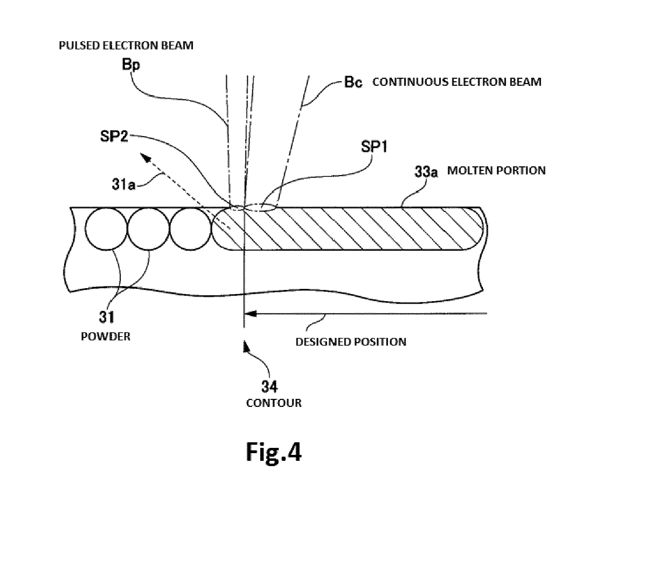

FIG. 4 is a vertical cross section of the powder 31 illuminated with the electron beam. In the example of FIG. 4, the right side of the contour 34 will form a 3D object, i.e., design positions of the 3D object. The left side of the contour 34 will not form any part of the 3D object. A position SP1 hit by the continuous electron beam $B_c$ is on the right side of the contour 34. With respect to another position SP2 hit by the pulsed electron beam $B_p$, the inside of the hit position SP2 is coincident with the contour 34. Owing to such illumination by the pulsed electron beam $B_p$, those portions of the powder 31 which are located outside the contour 34 become gas 31a and evaporate off.

The spot size at the position SP2 hit by the pulsed electron beam $B_p$ is smaller than the spot size at the position SP1 hit by the continuous electron beam $B_c$. In FIG. 4, for the sake of simplicity of explanation, it is assumed that the diameter of each grain of the powder 31 is the same as the thickness of one layer of molten portion 33a of the powder 31. In practice, the thickness of one layer of molten portion 33a may sometimes be greater than the diameter of each grain of the powder 31.

3. Characteristics of the Continuous Electron Beam and of the Pulsed Electron Beam

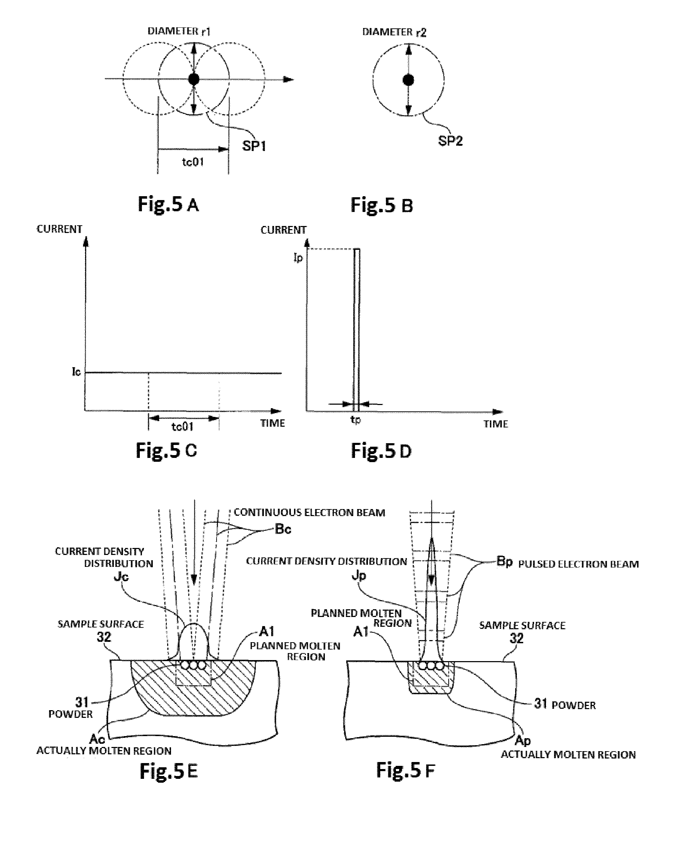

The characteristics of the continuous electron beam and of the pulsed electron beam are next described by referring to FIGS. 5-8. FIGS. 5A-5F show the characteristics of the continuous electron beam and of the pulsed electron beam. FIG. 5A shows variations in the position SP1 hit by the continuous electron beam. FIG. 5B shows the position SP2 hit by the pulsed electron beam. With respect to the continuous electron beam, as shown in FIG. 5A, when time $t_c 01$ elapses, the hit position moves a distance corresponding to the spot size (diameter of r1) at the hit position SP1. On the other hand, with respect to the pulsed electron beam, as shown in FIG. 5B, the powder is illuminated with a spot size having a diameter of $r_2$ at some timing. This illumination with the spot size of diameter r2 is done intermittently while varying the position.

As shown in FIG. 5C, in the case of the continuous electron beam, the current $I_c$ of the power supplied to the electron source 11 is constant. On the other hand, in the case of the pulsed electron beam, a current $I_p$ of a pulse width of a short duration $t_p$ is supplied. The current $I_p$ of the pulse width $t_p$ is supplied at regular intervals of time and so pulses of the electron beam are generated at regular intervals. The current $I_p$ of the pulsed electron beam is greater than the current $I_c$ of the continuous electron beam.

FIGS. 5E and 5F are cross-sectional views of the locations hit by the continuous electron beam and by the pulsed electron beam, showing examples in which the powder 31 is molten by being illuminated with an electron beam. FIG. 5E shows a case of the continuous electron beam $B_c$. FIG. 5F shows a case of the pulsed electron beam $B_p$.

In the case of the continuous electron beam $B_c$, the current density distribution $J_c$ of the electron beam $B_c$ hitting a sample surface 32 is spread over a relatively large area as shown in FIG. 5E. Therefore, if a planned molten region A1 where the powder 31 should be molten is substantially coincident with the spot size of the continuous electron beam $B_c$, an actually molten region $A_c$ where the powder 31 is actually molten spreads far from the spot size. The powder 31 is molten in regions where the powder should not be molten.

On the other hand, in the case of the pulsed electron beam $B_p$, the distribution $J_p$ of the current density of the electron beam $B_p$ hitting the sample surface 32 takes on a shape as shown in FIG. 5F. That is, the current density is quite high only at the hit position. Therefore, when the powder 31 is molten using the pulsed electron beam $B_p$, the actually molten region $A_p$ nearly coincident with the planned molten region A1 is obtained. Furthermore, in the additive manufacturing machine 100 according to the present embodiment, the current density distribution $J_p$ is appropriately controlled to make the temperature of the sample (i.e., the molten powder 31) higher than the temperature assumed when the sample is being molten, to sublimate and evaporate the sample.

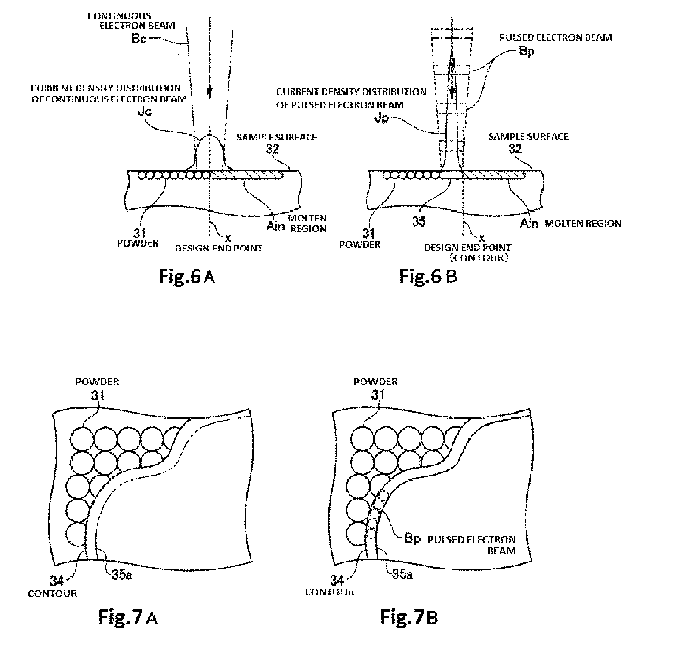

FIGS. 6A and 6B compare a state (FIG. 6A) in which the powder 31 has been molten by illumination by the continuous electron beam $B_c$ and a state (FIG. 6B) in which the powder 31 has been sublimated by illumination by the pulsed electron beam $B_p$. As shown in FIG. 6A, a molten region $A_{in}$ is formed by illumination with the continuous electron beam $B_c$. The molten area $A_{in}$ is spread by variation of the position on the sample surface 32 hit by the continuous electron beam $B_c$. At this time, the continuous electron beam $B_c$ melts the powder 31 up to a design end point x that corresponds to the contour 34 shown in FIG. 3. FIG. 6A shows a state in which the design end point x is coincident with an end of the molten region $A_{in}$. The molten region $A_{in}$ may spread slightly outwardly of the design end point x.

When the pulsed electron beam $B_p$ is emitted, an outside of the design end point x is selected as a sublimated region 35 as shown in FIG. 6B. The width of the sublimated region 35 is substantially coincident with the diameter of the spot size of the pulsed electron beam $B_p$. The depth of the sublimated region 35 is set nearly equal to the thickness of one layer of the tightly spread powder 31.

FIGS. 7A and 7B are views taken from above the sample surface 32. As shown in FIG. 7A, after the continuous electron beam $B_c$ has melted the powder 31 up to the contour 34, a sublimated region outside line 35a is set along the contour 34 so as to be spaced a given width from the contour 34. Then, as shown in FIG. 7B, the region between the contour 34 and the sublimated region outside line 35a is illuminated with the pulsed electron beam $B_p$ of a current density that sublimates the sample such that the beam $B_p$ is scanned sequentially across this region.

The characteristics of the pulsed electron beam $B_p$ are next described. Let $V_p(t)$ be the voltage generated by the pulsed voltage generator 23 shown in FIG. 1 when the pulsed electron beam $B_p$ is emitted. This voltage $V_p(t)$ is a pulsed voltage and is 0 (V) or $V_p$ (V) at time t. Let $V_c$ be the voltage generated by the extraction voltage generator 22 shown in FIG. 1. This voltage $V_c$ remains constant irrespective of time and generates the continuous electron beam $B_c$. These voltages $V_p(t)$ and $V_c$ are summed up by the adder 24. The sum voltage is applied to the extractor electrode 12. That is, a voltage $V_e(t)$ as given by the following Eq. (1) is applied to the extractor electrode 12.

$$V_e(t) = V_p(t) + V_c \qquad (1)$$

The extraction voltage $V_e$ is applied to the extractor electrode 12, increasing the electric field strength around the front end of the electron source 11. As a result, electrons are emitted. The continuous electron beam $B_c$ or the pulsed electron beam $B_p$ is accelerated by a voltage $V_a$ that is applied from the accelerating voltage generator 25 to the acceleration electrode 13. When the continuous electron beam $B_c$ is emitted, the extraction voltage $V_e(t)$ is given by

$$V_e(t) = V_c \qquad (2)$$

That is, when the continuous electron beam $B_c$ is being generated, the constant voltage $V_c$ is kept applied to the extractor electrode 12 and the continuous electron beam $B_c$ of constant current $I_c$ is being emitted. There is a linear relationship between the emission current and the extraction voltage $V_e(t)$. The emission current, $I_t(t)$, is given by

$$I_t(t) = I_p(t) + I_c \qquad (3)$$

where $I_c$ is an emission current corresponding to the voltage $V_c$, $I_p$ is an emission current corresponding to the voltage $V_p(t)$, and $t_p$ is the pulse width.

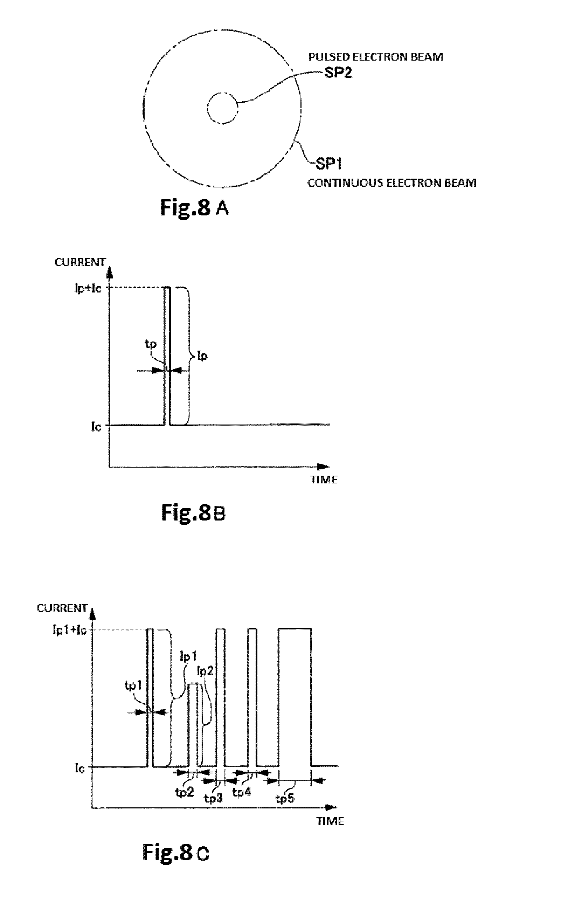

That is, the emission current $I_t(t)$ can be a function of time. This function can be varied by the current $I_c$, pulse width $t_p$, peak pulsed voltage $V_p$, and pulse frequency $v_p$ as shown in FIG. 8C, and is given by

$$I_t(t) = I_t(t;\ I_c, t_p, V_p, v_p) \qquad (4)$$

Energy E injected into the powdered sample by electron beam illumination is given by

$$E(t) = \int_0^t V_a \cdot I_t(t)\, dt = V_a \int_0^t I_t(t)\, dt \tag{5}$$

It can be seen from Eqs. (4) and (5) that the amount of energy injected into the sample can be controlled by four parameters i.e., $I_c$, $t_p$, $V_p$, and $v_p$. When it is assumed that $I_c = 0$, the emission current $I_t(t)$ is represented as shown in FIG. 5D. It is assumed that the sample is illuminated with only one pulse shown in FIG. 5D and that the injected energy gives an equality as given by Eq. (6). That is, an area determined by both the duration of the interval $t_c01$ and the current while the continuous current shown in FIG. 5C is being supplied is equal to an area determined by both the pulse interval $t_p$ shown in FIG. 5D and the current.

$$\int_0^{t_c01} I_c\, dt = \int_0^{t_p} I_p\, dt \tag{6}$$

The brightness B ($A/m^2/sr$) of an electron beam is given by the following Eq. (7) and has the property that it is constant along the optical axis.

$$B = \frac{\beta_p}{\pi r_p^2} \tag{7}$$

where $\beta_p$ is the angular current density on the sample surface and $r_p$ is the diameter of the pulsed electron beam on the sample surface. Therefore, the diameter $r_p$ of the pulsed electron beam $B_p$ is given by

$$r_p = \sqrt{\frac{\beta_p}{\pi B}} \tag{8}$$

Usually, the brightness of the pulsed electron beam is higher than the brightness of the continuous electron beam and, therefore, if the angular current density is constant, the diameter of the continuous electron beam is smaller than the diameter of the pulsed electron beam. The continuous electron beam of FIG. 5E and the pulsed electron beam of FIG. 5F show this state. The amount of injected energy is the same for both of the continuous electron beam of FIG. 5E and the pulsed electron pulse of FIG. 5F. The current density distribution $J_p$ shown in FIG. 5F is a current density distribution assumed when the sample is illuminated with one pulse.

As can be seen by comparison of FIGS. 5E and 5F, the current density distribution of the pulsed electron beam has a higher peak value and a smaller half-value width. Although the amount of the injected energy is the same in this case, the time in which the planned molten region A1 is molten is much shorter in the case of the pulsed electron pulse. That is, where the amount of the injected energy is the same, the spot size at the position SP2 hit by the pulsed electron beam is smaller than the spot size at the position SP1 hit by the continuous electron beam as shown in FIG. 8A. Consequently, in the case of the pulsed electron beam, almost no heat transmission occurs. The sample undergoes no heat damage. The planned molten region A1 and the actually molten region $A_p$ are almost equal.

In the case of the continuous electron beam, energy is injected for a prolonged time. Heat is propagated to the outside of the planned molten region A1. In some cases, the planned molten region A1 may not be fully molten, resulting in defects. In the case of the continuous electron beam, heat is propagated to the surroundings of the planned molten region A1, causing heat damage to the sample. If a higher energy is injected in an attempt to fully melt the planned molten region A1, it brings broadening the region subjected to heat damage.

In the additive manufacturing machine 100, when the pulsed electron beam $B_p$ is produced, a pulsed voltage to which a bias voltage is added is applied to the extractor electrode 12. That is, as shown in FIG. 8B, when the current $I_c$ based on the voltage $V_c$ applied by the extraction voltage generator 22 is not 0, the emission current $I_t(t)$ is the sum of the current $I_c$ and the current $I_p$. At this time, the current density distribution at the sample surface varies with time. That is, sometimes the current density distribution is the current density distribution of the continuous electron beam, and sometimes the distribution is the sum of the current density distribution of the pulsed electron beam and the current density distribution of the continuous electron beam.

The bias voltage $V_c$ applied by the extraction voltage generator 22 when the pulsed electron beam $B_p$ is produced is used for a pretreatment where the powder 31 is not fully molten but the temperature is raised to an appropriate temperature. For example, this pretreatment is performed using only the continuous electron beam. Then, the pulsed voltage $V_p$ is added to the bias voltage $V_c$, and the pulsed electron beam is generated to melt or sublimate the powder.

In the example of FIG. 8C, the current and the pulse width are finely controlled when the pulsed electron beam is used. Specifically, as shown in FIG. 8C, the continuous electron beam current $I_c$, pulse width $t_p$, pulsed voltage $V_p$, and pulse frequency $v_p$ may be combined optimally according to conditions used when a three-dimensional object is fabricated such that the additive manufacturing is controlled finely. In the example of FIG. 8C, two kinds of currents, $I_p1$ and $I_p2$, are selectively used as the current for generating the pulsed electron beam. Furthermore, pulse widths $t_{p1}$, $t_{p2}$, $t_{p3}$, $t_{p4}$, $t_{p5}$, and so forth are varied according to the conditions. The additive manufacturing process can be finely controlled by the use of the pulsed electron beam in this way.

4. Example of Control Provided by Controller

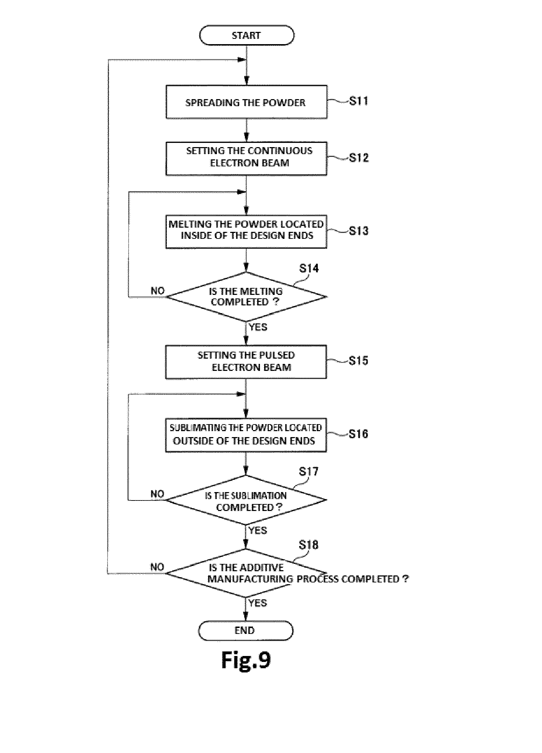

An example of control operation performed by the controller 21 when a 3D object is fabricated by the additive manufacturing machine 100 according to one embodiment of the present invention is next described by referring to the flowchart of FIG. 9. First, the controller 21 gives an instruction to spread one layer of the powder 31 tightly over the support stage 43 using the linewise funnel (not shown) (step S11). When this spreading operation is complete, the controller 21 gives an instruction regarding a voltage to the extraction voltage generator 22 to emit the continuous electron beam (step S12).

The controller 21 directs the continuous electron beam at the powder 31 located inside of the design ends of the 3D object to melt the powder 31 at the hit positions (step S13). The controller 21 makes a decision as to whether the melting of the powder 31 located inside of the design ends of the 3D object is completed (step S14). If the melting of the powder 31 is not complete, the melting operation of step S13 is performed.

If the decision at step S 14 is affirmative to indicate that the melting of the powder 31 inside of the design ends is completed, the controller 21 gives an instruction about a voltage to the pulsed voltage generator 23 such that the pulsed electron beam is emitted (step S15). The controller 21 directs the pulsed electron beam at the powder 31 located outside of the design ends of the 3D object and along the design ends to sublimate the powder 31 at the hit positions (step S16). The controller 21 makes a decision as to whether the sublimation of the powder portions located along the design ends of the 3D object is completed (step S17). If the sublimation of the powder 31 is not completed, the sublimation operation of step S16 is performed.

If the decision at step S 17 is affirmative to indicate that the sublimation of the powder portions present along the design ends is completed, the controller 21 makes a decision as to whether the additive manufacturing process is completed (step S18). If the process is not completed, control goes back to step S11, where the operation for tightly spreading the powder 31 to form the next layer is performed. In the additive manufacturing machine 100, the sequence of processing operations from step S11 to step S16 is repeated as many times as there are layers required. If the decision at step S18 is that the additive manufacturing process is completed, the controller 21 ends the operation of the multilayered fabrication for the single 3D object.

As described so far, the additive manufacturing machine 100 of the present embodiment can produce an accurate 3D multilayered object using two kinds of beams, i.e., the continuous electron beam and the pulsed electron beam. That is, by forming the contour of the 3D object through sublimation using the pulsed electron beam, the surface roughness of the 3D object does not depend on the grain diameter of the powder 31. Consequently, the surface roughness of the 3D object can be improved. In addition, that the surface roughness of the 3D object does not depend on the grain diameter of the powder 31 makes it unnecessary to reduce the grain diameter of the powder 31. This contributes to improvement of the speed at which additive manufacturing is performed.

Furthermore, the additive manufacturing machine 100 according to the present embodiment can perform an accurate additive manufacturing process where the range in which the powder is molten or sublimated by the pulsed electron beam is substantially coincident with the beam diameter by performing the process through the use of the pulsed electron beam. As a result, the accuracy at which a 3D multilayered object is fabricated can be improved. In the present embodiment described so far, the pulsed electron beam is used when the powder is sublimated. Alternatively, the pulsed electron beam may melt the powder by setting the current of the pulsed electron beam to such an extent as to melt the powder.

Additionally, the addition of a constant bias voltage to the pulsed voltage for producing the pulsed electron beam can better the additive manufacturing process. By superimposing a voltage, for example, for heating the powder on the bias voltage, there arises the advantage that the pulsed electron beam can be emitted while performing the heating operation.

5. Modifications

In the additive manufacturing machine according to the above embodiment, the pulsed electron beam is used when the powder is sublimated. Alternatively, the pulsed electron beam may be used when the powder is molten. That is, when the powder portions located inside the contour line of a 3D object to be fabricated are molten, the electron source 11 may direct a pulsed electron beam at the powder 31. The controller 21 can more accurately define the molten region by using the pulsed electron beam in this way.

Furthermore, the process for sublimating the outside of the contour constitutes only one example. Alternatively, the pulsed electron beam may be used only to melt the powder. A 3D multilayered object may be fabricated without performing sublimation.

Further, the process for superimposing the voltage for heating the powder on the pulsed voltage constitutes only one example. The bias voltage for heating purposes may not be superimposed.

The above-described embodiment is the additive manufacturing machine having the electron source 11 emitting an electron beam at the powder 31. The additive manufacturing machine of the present invention may also be applied to other machine having other beam generator producing a laser beam. For example, in the case of an additive manufacturing machine emitting a laser beam at powder, a continuous laser beam and a pulsed laser beam are prepared as laser beams. The outside of the contour of a 3D object is sublimated using the pulsed laser beam.

It is to be understood that the configurations of the various parts of the additive manufacturing machine shown in the above embodiment are merely exemplary and that the present invention is not restricted thereto. For example, in the configurations shown in FIG. 1, lenses other than the objective lens 14 and the deflector lens 15 may be mounted in locations through which the electron beam B passes.

**Claims**

1. An additive manufacturing machine comprising:

   a support stage on which a powdered material is spread tightly;
   a beam generator producing a beam;
   a lens for focusing the beam produced by the beam generator onto the powdered material spread on the support stage; and
   a controller for causing the beam generator to produce a pulsed beam as the beam produced by the beam generator.

2. The additive manufacturing machine of claims 1 wherein the beam generator is an electron gun and the beam is an electron beam.

3. The additive manufacturing machine of claim 1 or 2 where the controller is for causing the beam generator to selectively produce a continuous beam and a pulsed beam as the beam produced by the beam generator.

4. An additive manufacturing machine as set forth in claim 3, wherein said controller melts said powdered material by illuminating the powdered material with said continuous beam and sublimates the powdered material by illuminating the powdered material with said pulsed beam.

5. An additive manufacturing machine as set forth in claim 4, wherein said controller controls said lens such that a diameter of the beam used when the powdered material is sublimated is smaller than a diameter of the beam used when the powdered material is molten.

6. An additive manufacturing machine as set forth in claim 1, wherein said beam generator is an electron gun producing an electron beam, and wherein the electron gun selectively produces a continuous electron beam and a pulsed electron beam under control of said controller.

7. An additive manufacturing machine comprising:

   a support stage on which a powdered material is spread tightly;
   an electron gun producing an electron beam;
   a lens for focusing the electron beam produced by the electron gun onto the powdered material spread on the support stage; and

a controller for causing the electron gun to produce a pulsed electron beam as the electron beam produced by the electron gun.

8. An additive manufacturing machine as set forth in claim 7, wherein said controller melts or sublimates the powdered material by illuminating the powdered material with said pulsed electron beam.

9. An additive manufacturing machine as set forth in claim 8, wherein said controller supplies a drive voltage to said electron gun, the drive voltage being produced by superimposing a pulsed voltage on an offset voltage for heating the electron gun.

10. An additive manufacturing machine as set forth in claim 9, wherein each pulse of said pulsed electron beam has a duration shorter than 1 microsecond.

11. A method of fabricating a three-dimensional multilayered object by spreading a powdered material tightly on a support stage, illuminating the powdered material with a beam, and melting and bonding together grains of the powdered material to obtain the three-dimensional object, said method comprising the step of:

    selectively producing a continuous beam and a pulsed beam as the illuminating beam.

12. A method of fabricating a three-dimensional multilayered object by spreading a powdered material tightly on a support stage and illuminating the powdered material with an electron beam from an electron gun to melt and cure the powdered material, said method comprising the step of:

    producing a pulsed beam as the electron beam produced by the electron gun to melt or sublimate the powdered material.

EP 2 918 396 A1

Fig.1

11

**Bc** CONTINUOUS ELECTRON BEAM

SUPPORT PLATFORM
41

SAMPLE SURFACE
32

3D OBJECT
33

POWDER
31

43
SUPPORT STAGE

42
CENTRAL PIT

34
CONTOUR

**Fig.2**

PULSED ELECTRON BEAM
Bp

SUPPORT PLATFORM
41

3D OBJECT
33

CONTOUR
34

SUBLIMATED
REGION
35

POWDER
31

43 SUPPORT STAGE

42 CENTRAL PIT

Fig.3

EP 2 918 396 A1

Fig.4

14

**Fig.5** A

**Fig.5** B

**Fig.5** C

**Fig.5** D

**Fig.5** E

**Fig.5** F

CONTINUOUS
ELECTRON BEAM
Bc

CURRENT DENSITY DISTRIBUTION
OF CONTINUOUS ELECTRON BEAM
Jc

SAMPLE SURFACE
32

Ain MOLTEN REGION

31
POWDER

x
DESIGN END POINT

Fig.6 A

PULSED ELECTRON BEAM
Bp

CURRENT DENSITY DISTRIBUTION
OF PULSED ELECTRON BEAM
Jp

SAMPLE SURFACE
32

35

Ain MOLTEN REGION

31
POWDER

x
DESIGN END POINT
(CONTOUR)

Fig.6 B

POWDER
31

34
CONTOUR

35a

Fig.7 A

POWDER
31

Bp PULSED ELECTRON
BEAM

34
CONTOUR

35a

Fig.7 B

PULSED ELECTRON BEAM
SP2

SP1
CONTINUOUS ELECTRON BEAM

Fig.8 A

Fig.8B

Fig.8 C

START

SPREADING THE POWDER ———S11

SETTING THE CONTINUOUS
ELECTRON BEAM ———S12

MELTING THE POWDER LOCATED
INSIDE OF THE DESIGN ENDS ———S13

S14
NO ← IS THE MELTING
COMPLETED ?

YES

SETTING THE PULSED
ELECTRON BEAM ———S15

SUBLIMATING THE POWDER LOCATED
OUTSIDE OF THE DESIGN ENDS ———S16

S17
NO ← IS THE SUBLIMATION
COMPLETED ?

YES

S18
NO ← IS THE ADDITIVE
MANUFACTURING PROCESS COMPLETED ?

YES

END

# Fig.9

Europäisches
Patentamt

European
Patent Office

Office européen
des brevets

# EUROPEAN SEARCH REPORT

Application Number

EP 15 15 8295

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 182 170 A (MARCUS HARRIS L [US] ET AL) 26 January 1993 (1993-01-26) | 1,3 | INV. B29C67/00 |
| A | * column 6, line 28 - column 7, line 3; figures 1,2 * | 2,4-12 | B22F3/105 B33Y10/00 B33Y30/00 |
| X | US 2013/300286 A1 (LJUNGBLAD ULRIC [SE] ET AL) 14 November 2013 (2013-11-14) | 1-3,7,8, 12 | B33Y50/02 |
| A | * paragraph [0045]; figure 3 * * paragraph [0047] * * paragraph [0064] * * paragraph [0067] * | 4-6,9-11 | |
| X | US 2013/154160 A1 (COOPER GUTHRIE [US]) 20 June 2013 (2013-06-20) * claim 1; figure 1a * | 1,3 | |

TECHNICAL FIELDS SEARCHED (IPC)

B29C
B22F
B33Y

The present search report has been drawn up for all claims

| Place of search | Date of completion of the search | Examiner |
|---|---|---|
| The Hague | 2 July 2015 | Pierre, Nathalie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 15 15 8295

This annex lists the patent family members relating to the patent documents cited in the above-mentioned European search report.
The members are as contained in the European Patent Office EDP file on
The European Patent Office is in no way liable for these particulars which are merely given for the purpose of information.

02-07-2015

| Patent document cited in search report | | Publication date | Patent family member(s) | | Publication date |
|---|---|---|---|---|---|
| US 5182170 | A | 26-01-1993 | NONE | | |
| US 2013300286 | A1 | 14-11-2013 | CN | 104272425 A | 07-01-2015 |
| | | | EP | 2847782 A2 | 18-03-2015 |
| | | | KR | 20150010946 A | 29-01-2015 |
| | | | US | 2013300286 A1 | 14-11-2013 |
| | | | WO | 2013167391 A2 | 14-11-2013 |
| US 2013154160 | A1 | 20-06-2013 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2001152204 A